Europäisches Patentamt

European Patent Office

Office européen des brevets

(19)

(11) Numéro de publication: **0012315**
**A1**

## (12) DEMANDE DE BREVET EUROPEEN

(21) Numéro de dépôt: **79104848.1**

(22) Date de dépôt: **03.12.79**

(51) Int. Cl.³: **H 02 J 7/10, G 01 R 31/36**

(30) Priorité: **07.12.78 FR 7834473**

(43) Date de publication de la demande: **25.06.80**
**Bulletin 80/13**

(84) Etats contractants désignés: **BE DE GB IT LU NL**

(71) Demandeur: **S.A. dite: SAFT - SOCIETE DES ACCUMULATEURS FIXES ET DE TRACTION, 156, avenue de Metz, F-93230 Romainville (FR)**

(72) Inventeur: **Belot, Pierre, 111, allée Danièle Casanova, F-93320 Pavillons sous Bois (FR)**

(74) Mandataire: **Weinmiller, Jürgen et al, Zeppelinstrasse 63, D-8000 München 80 (DE)**

(54) **Procédé et dispositif de suivi de l'état de charge d'un accumulateur.**

(57) L'invention concerne la charge des accumulateurs.

Le suivi de l'état de charge consiste à élaborer une grandeur g proportionnelle au courant I de charge ou de décharge de l'accumulateur, à intégrer algébriquement ladite grandeur en une information qui est l'image de l'état de charge de l'accumulateur, en donnant au coefficient de proportionnalité a = g/I entre ladite grandeur et ledit courant une valeur plus faible en charge qu'en décharge, et à faire varier la valeur du coefficient a en charge en fonction croissante du courant I.

Application aux accumulateurs.

# Procédé et dispositif de suivi de l'état de charge d'un accumulateur

L'invention concerne le suivi de l'état de charge d'un accumulateur.

On sait que pour recharger complètement un accumulateur préalablement déchargé d'une quantité d'électricité Qo, il faut lui fournir une quantité d'électricité kQo, le facteur k, appelé coefficient ou facteur de recharge, étant supérieur à 1 et représentant l'inverse du rendement de charge de l'accumulateur. Le facteur de recharge appliqué doit être déterminé avec soin : s'il est trop faible, l'accumulateur ne sera pas rechargé suffisamment, s'il est trop élevé, l'accumulateur sera surchargé, ce qui se traduira par des inconvénients divers selon le type et le mode d'utilisation de l'accumulateur, le moins grave de ces inconvénients étant la contrainte constituée par la maintenance du niveau d'électrolyte pour un accumulateur ouvert, et le plus grave étant la destruction de l'accumulateur qui peut survenir par court-circuit, par explosion ou par échauffement selon le cas.

Pour déterminer la quantité d'électricité nécessaire à la recharge correcte, il est connu de suivre en permanence l'état de charge de l'accumulateur en élaborant une grandeur g proportionnelle au courant I de charge ou de décharge qui le traverse, et en intégrant algébriquement cette grandeur en une information qui est l'image de l'état de charge de l'accumulateur. Le coefficient de proportionnalité $\underline{a} = \frac{g}{I}$ est choisi différent en charge et en décharge, pour tenir compte justement du rendement de charge de l'accumulateur, et la charge est arrêtée lorsque l'information image représente l'état de charge complète de l'accumulateur.

On a toutefois constaté que pour certains types d'accumulateurs, notamment les accumulateurs nickel-cadmium, le choix de deux valeurs différentes pour le coefficient a en charge et en décharge n'est pas suffisant pour assurer une recharge optimale des accumulateurs lorsque le courant de charge n'est pas constant.

Le but de l'invention est de remédier à cette insuffisance.

L'invention a pour objet un procédé de suivi de l'état de charge d'un accumulateur, et dans lequel on fait varier la valeur du

coefficient $\underline{a}$ en charge en fonction croissante du courant I.

Le procédé selon l'invention tient compte du fait que le rendement de charge des accumulateurs concernés, toujours inférieur à 1, est d'autant plus faible que le régime de charge, c'est-à-dire le courant de charge rapporté à la capacité, est lui-même faible.

L'invention a également pour objet un dispositif pour la mise en oeuvre de ce procédé, comprenant :

- un shunt placé en série avec l'accumulateur et dont la tension aux bornes est algébriquement proportionnelle au courant I,

- un circuit d'amplification fournissant une tension amplifiée proportionnelle à la tension aux bornes du shunt,

- un convertisseur tension-fréquence délivrant un train d'impulsions dont la fréquence, constituant ladite grandeur g, est proportionnelle à la valeur absolue de ladite tension amplifiée, avec un coefficient de proportionnalité fonction du signe de cette dernière, et de sa valeur absolue lorsque l'accumulateur est en charge,

- un circuit de comptage logique, sensible auxdites impulsions et au signe de la tension aux bornes du shunt, comptant positivement ou négativement lesdites impulsions selon ledit signe, et dont l'état logique représente ladite information.

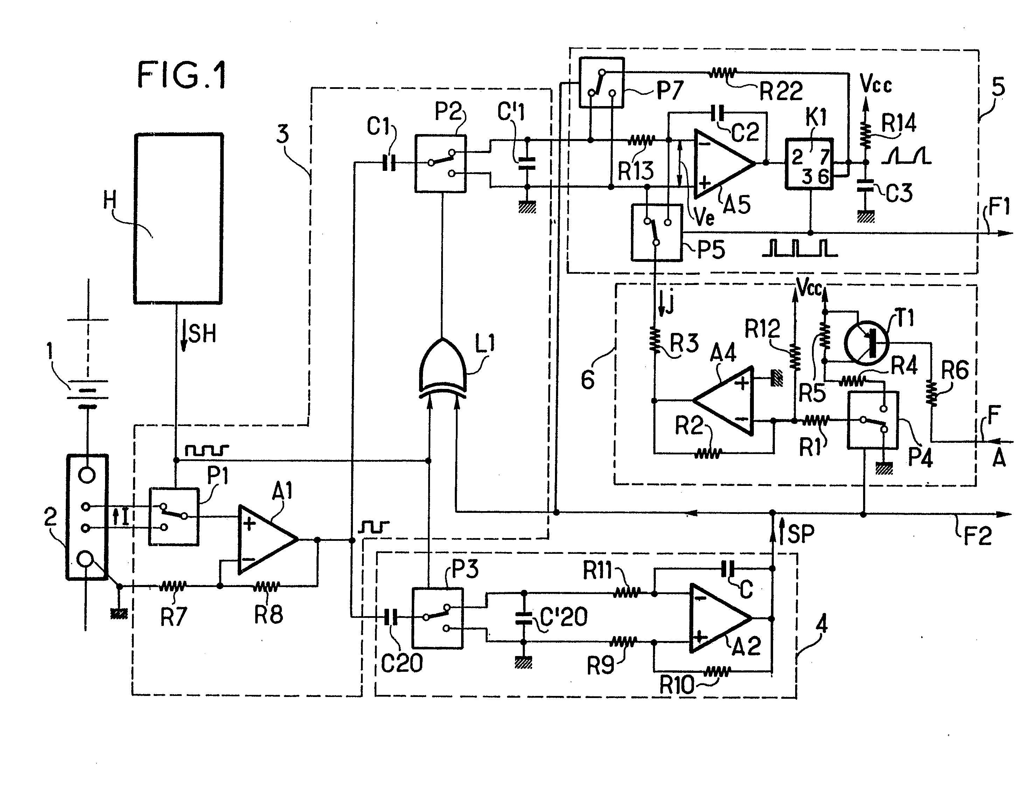

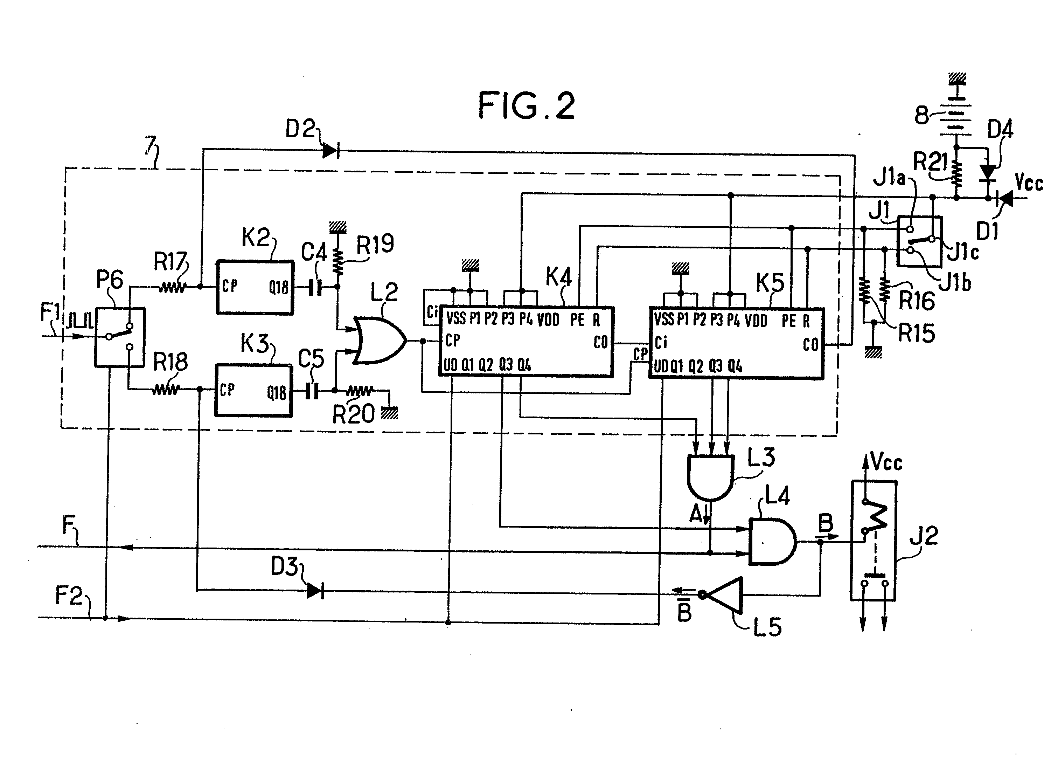

L'invention sera mieux comprise grâce à un exemple de réalisation donné ci-après à titre illustratif et non limitatif, en regard du dessin annexé dans lequel les figures 1 et 2 constituent ensemble le schéma électrique d'un dispositif selon l'invention.

On voit à la figure 1 que le courant I de charge ou de décharge d'une batterie d'accumulateurs 1 traverse un shunt 2 branché en série avec celle-ci. La tension aux bornes du shunt est injectée à l'entrée d'un circuit d'amplification à découpage 3. Ce circuit comprend un premier inverseur analogique P1 commandé par une horloge H, alimentée par la batterie 1. L'horloge fournit à l'inverseur P1 un signal périodique rectangulaire SH de fréquence 1 kHz par exemple, constitué par un niveau de tension nulle pendant une première alternance et un niveau de tension positive appelée $V_{cc}$ pendant la seconde alternance, ces deux niveaux étant représentés dans la suite respectivement par les deux chiffres 0 et 1. L'inverseur P1 ainsi commandé, et relié par ses deux contacts aux bornes du shunt 2, transforme la tension d'entrée en une tension périodique dont l'amplitude de variation est égale à la valeur algébrique de la tension d'entrée.

Le circuit d'amplification à découpage 3 comprend également un amplificateur opérationnel A1 dont l'entrée non inverseuse est reliée au point commun de l'inverseur analogique P1, et dont l'entrée inverseuse est reliée, d'une part à la masse par une résistance R7, et d'autre part à la sortie de l'amplificateur opérationnel par une résistance R8.

L'amplificateur opérationnel A1 délivre en sortie une tension alternative amplifiée dont l'amplitude est proportionnelle à ladite tension périodique, et en phase avec celle-ci. La sortie de l'amplificateur opérationnel A1 est reliée à travers un condensateur C1 au point commun d'un second inverseur analogique P2 commandé par le signal d'horloge SH par l'intermédiaire d'une porte logique OU exclusif L1 ; un condensateur C'1 est branché entre les deux contacts de l'inverseur analogique P2, et l'une de ses bornes est reliée à la masse.

La porte L1 reçoit sur l'une de ses entrées le signal SH de l'horloge et sur l'autre entrée un signal SP, dont on verra plus loin comment il est élaboré, qui prend la valeur 1 lorsque la batterie 1 est en charge et la valeur 0 lorsqu'elle est en décharge. Le signal de sortie de la porte L1, qui est envoyé à l'inverseur P2 est donc identique au signal SH lorsque la batterie est en décharge et au signal $\overline{SH}$ lorsque la batterie est en charge, et l'inverseur P2 fonctionne en synchronisme avec l'inverseur P1 lors de la décharge et en opposition lors de la charge, de telle sorte qu'il démodule la tension alternative amplifiée en une tension de signe constant. Cette tension démodulée devient après filtrage une tension continue proportionnelle à l'amplitude de la tension alternative amplifiée, donc au courant traversant le shunt 2.

Le signal SP est fourni sur un fil F2 par un détecteur de polarité 4, qui comprend un troisième inverseur analogique P3 commandé par le signal d'horloge SH et dont le point commun est relié à la sortie de l'amplificateur opérationnel A1 à travers un condensateur $C_{20}$ ; un condensateur $C'_{20}$ est branché entre les deux contacts de l'inverseur analogique P3 et l'une de ses bornes est reliée à la masse ; un second amplificateur opérationnel A2 a son entrée non inverseuse reliée d'une part à la borne du condensateur $C'_{20}$ relié à la masse par une résistance R9, et d'autre part à sa sortie par une résistance R10 ; l'entrée inverseuse de l'amplificateur opérationnel A2 est reliée d'une part à l'autre borne du condensateur $C'_{20}$ par une résistance R11, et d'autre part à sa sortie par un condensateur C. L'inverseur analogique P3 transforme la tension alternative de sortie de l'amplificateur opérationnel A1 en une tension continue dont le signe est le même que celui de la tension d'entrée ; cette tension continue est transmise à l'amplificateur opérationnel A2 monté en hystérésis de tension et dont la sortie délivre le signal SP représentant le sens du courant I de charge ou de décharge de la batterie.

La tension continue amplifiée issue de l'inverseur analogique P2 est envoyée à l'entrée d'un convertisseur tension-fréquence 5, qui sera décrit plus loin, et qui élabore un train d'impulsions à une fréquence f proportionnelle à cette tension continue donc au courant I. Cette fréquence f constitue la grandeur g évoquée dans la définition de l'invention. Le coefficient de proportionnalité $\underline{a} = \frac{f}{I}$ est influencé par un générateur de courant 6.

Le générateur de courant 6 comprend un amplificateur opérationnel A4 dont l'entrée non inverseuse est reliée à la masse (potentiel zéro) et l'entrée inverseuse, par l'intermédiaire d'une résistance R1, au point commun d'un inverseur analogique P4, et par l'intermédiaire d'une résistance R12 au potentiel $V_{cc}$. La sortie de l'amplificateur A4 est reliée à son entrée inverseuse par une résistance R2 et à la sortie du générateur par une résistance R3. L'un des contacts de l'inverseur P4 est au potentiel zéro et l'autre est relié au potentiel $V_{cc}$ par une chaîne de résistances R4, R5 dont une partie R5 est en parallèle avec le trajet émetteur-collecteur d'un transistor T1. L'inverseur P4 est commandé par le signal SP fourni par l'amplificateur A2. Il relie la résistance R1, lorsque la batterie 1 est en décharge (SP = 0), à la masse, et lorsque la batterie est en charge (SP = 1), à la résistance R4. Par ailleurs un signal de polarisation A, acheminé par un fil F, est appliqué par l'intermédiaire d'une résistance R6 sur la base du transistor T1 ; ce signal de polarisation est fonction d'une information image de l'état de charge de la batterie 1, fournie par un circuit de comptage 7 représenté à la figure 2, intégrant les impulsions émises par le convertisseur 5. Lorsque l'information image indique un état de charge au moins égal à une valeur prédéterminée, le signal de polarisation A a la valeur 1 ($V_{cc}$), le transistor T1 est donc bloqué et les résistances R4 et R5 sont interposées en série entre $V_{cc}$ et l'entrée de l'inverseur P4, qui se trouve portée à un potentiel intermédiaire entre 0 et $V_{cc}$. Dans le cas contraire le signal de polarisation A a la valeur 0, le transistor T1 est saturé et court-circuite la résistance R5. Le potentiel à l'entrée de l'inverseur P4 est donc plus élevé que précédemment. Ainsi le potentiel à la sortie de l'inverseur P4, donc à l'entrée négative de l'amplificateur A4 et par suite le courant j créé par le générateur de courant 6 peuvent prendre trois valeurs différentes selon le sens du courant I et l'état de charge de la batterie. On a $j = j_o$ lorsque la batterie est en décharge, $j = j_1 > j_o$ lorsque la batterie est en charge, son état de charge étant au moins égal à la valeur de seuil, et $j = j_2 > j_1$ lorsque la batterie est en charge, son état de charge étant inférieur.

Le convertisseur tension-fréquence 5 comprend un amplificateur opérationnel A5 dont les entrées non inverseuse et inverseuse reçoivent la tension amplifiée continue fournie par l'inverseur P2 du circuit 3, l'entrée non inverseuse étant reliée à la borne du condensateur C'1 reliée à la masse, l'entrée inverseuse étant reliée à l'autre borne dudit condensateur C'1 à travers une résistance R13, et dont la sortie est reliée à la borne codée 2 d'un circuit monostable intégré K1 du type 555. Les bornes codées 6 et 7 du circuit K1 sont reliées conjointement d'une part au potentiel $V_{cc}$ à travers une résistance R14, d'autre part à la masse à travers un condensateur C3, et enfin par une résistance R22 au point commun d'un inverseur analogique P7 commandé par le signal SP et dont les contacts sont reliés respectivement à ceux de l'inverseur P2. Un condensateur C2 est branché entre l'entrée inverseuse et la sortie de l'amplificateur opérationnel A5. En parallèle avec les entrées de celui-ci sont branchés les contacts d'un inverseur analogique P5, commandé par les impulsions à la fréquence f fournies par la borne codée 3 reliée à un fil F1, du circuit monostable K1, et dont le point commun est relié à la sortie du générateur de courant 6. Un signal en dents de scie est produit à la sortie de l'amplificateur A5 et transformé par le circuit monostable K1 en un train d'impulsions rectangulaires, la fréquence f de ce signal en dents de scie et de ce train d'impulsions étant proportionnelle à la tension d'entrée $V_e$ du convertisseur 5, donc au courant traversant la batterie 1, avec un coefficient $\underline{a} = \frac{f}{I}$ inversement proportionnel au courant j produit par le générateur de courant 6 et à la durée h des impulsions positives.

Cette durée h est le temps nécessaire pour charger le condensateur C3 à la tension $2V_{cc}/3$. Lors de la décharge de la batterie 1, l'inverseur P7 relie la résistance R22 à la masse. Cette résistance est donc branchée directement en parallèle sur le condensateur C3, et on a :

$$h_o = - \frac{R14.R22.C}{R14 + R22} \quad Log \quad (1 - \frac{2}{3} \frac{R14 + R22}{R22})$$

C étant la capacité du condensateur C3.

Lors de la charge de la batterie 1, l'inverseur P7 relie la résistance R22 au pôle positif de la tension d'entrée $V_e$, laquelle se trouve donc en série avec R22 entre les armatures de C3. On a alors :

$$h_1 = - \frac{R14.R22.C}{R14 + R22} \quad Log \quad (1 - \frac{2}{3} \frac{R14 + R22}{R22 + \frac{V_e}{V_{cc}} R14})$$

Le train d'impulsions à la fréquence f est envoyé par le fil F1 au point commun d'un inverseur analogique P6 du circuit de comptage logique 7 représenté à la figure 2. L'inverseur analogique P6 commandé par le signal SP, fil F2, dirige les impulsions vers un premier diviseur de fréquence K2 à travers une résistance R17 lorsque la batterie est en décharge, et vers un deuxième diviseur de fréquence K3 à travers une résistance R18 lorsque la batterie est en charge. Les diviseurs K2 et K3 sont des circuits intégrés du type 14 521. Ces diviseurs divisent par $2^{18}$ la fréquence appliquée à leur entrée CP, c'est-à-dire que lorsque l'un d'eux reçoit le train d'impulsions à la fréquence f, il produit un signal de sortie rectangulaire de fréquence $2^{-18}f$. Les sorties Q18 des diviseurs K2 et K3 sont reliées respectivement par des condensateurs C4 et C5 aux entrées d'une porte logique OU, L2, de telle sorte que l'apparition d'un niveau 1 à la sortie de l'un des diviseurs, correspondant à la production de $2^{18}$ impulsions

par le convertisseur 5, se traduit par l'apparition d'un niveau 1 fugitif à la sortie de la porte L2 ; le point commun au condensateur C4 et à l'entrée correspondante de la porte OU L2 est relié à la masse par une résistance R19 ; le point commun au condensateur C5 et à l'entrée correspondante de la porte OU L2 est relié à la masse par une résistance R20. Ce niveau de sortie est transmis aux entrées CP de deux compteurs logiques K4 et K5 du type 14 516, la sortie Co ($\overline{\text{carry out}}$) du compteur K4 étant reliée à l'entrée Ci ("carry in") du compteur K5. Ces deux compteurs ainsi associés se comportent comme un seul compteur à 256 états logiques, états qu'on désignera dans la suite par un nombre binaire de huit chiffres, les quatre premiers représentant l'état du compteur K5 et les quatre derniers celui du compteur K4.

Les entrées UD ("up/down") des deux compteurs reçoivent par le fil F2 le signal SP issu de l'amplificateur A2, de façon à compter les impulsions qu'ils reçoivent positivement en charge et négativement en décharge. L'état logique du circuit de comptage résulte ainsi de l'intégration algébrique de la fréquence f, proportionnelle au courant I traversant la batterie 1, et constitue une information image de l'état de charge de cette batterie.

Les entrées P1 et P2 ("preset" 1 et 2) des compteurs K4 et K5 sont au niveau 0 et leurs entrées P3 et P4 ("preset" 3 et 4) au niveau 1. Les bornes PE ("preset enable") des deux compteurs sont reliées à un contact fixe J1a d'un interrupteur J1 à trois positions, et à une extrémité d'une résistance R15 dont l'autre extrémité est au niveau 0. Les bornes R ("reset") des compteurs sont reliées à un autre contact fixe J1b de l'interrupteur J1, et à une extrémité d'une résistance R16 dont l'autre extrémité est également au niveau 0. Le contact mobile J1c de l'interrupteur J1 est relié à la cathode d'une diode D1 dont l'anode est au niveau 1 ($V_{cc}$).

Le décodage de l'état des compteurs est assuré de la façon suivante. Une diode D2 est branchée dans le sens direct entre l'entrée CP du diviseur K2 et la borne Co ($\overline{\text{carry out}}$) du compteur K5. Les bornes Q4 des compteurs K4 et K5, et Q3 du compteur K5 sont reliées aux trois entrées d'une porte logique ET, L3, qui délivre en sortie le signal de polarisation A, la sortie de la porte ET L3 étant raccordée au fil F et à l'entrée d'une porte logique ET, L4 ; une autre entrée de la porte ET, L4 est reliée à la borne Q3 du compteur K4. La sortie de la porte ET, L4 est reliée à une extrémité de la bobine d'un relais J2 dont l'autre extrémité est au potentiel $V_{cc}$, les contacts de ce relais étant insérés dans un circuit, non représenté, de charge rapide de la batterie 1. Une diode D3 est branchée dans le sens direct entre l'entrée CP du diviseur K3 et la sortie d'un inverseur logique L5, dont l'entrée est reliée à la sortie de la porte ET, L4.

Le fonctionnement d'ensemble du dispositif sera décrit en considérant que la batterie 1 est utilisée en secours, c'est-à-dire qu'elle est normalement maintenue à l'état chargé par un chargeur à partir d'une source qui alimente par ailleurs une utilisation, et à laquelle elle se substitue en cas de défaillance. Ce fonctionnement serait le même si la batterie était utilisée en tampon, avec une régulation appropriée du courant de charge.

On suppose qu'à la mise en service du dispositif la batterie 1 est complètement chargée. En établissant momentanément la liaison J1a-J1c par l'interrupteur J1, on donne au circuit de comptage l'état 11001100, qui constitue l'image de l'état de charge complète de la batterie. Les signaux de sortie A et B des portes L3 et L4, respectivement, sont au niveau 1, et le signal $\overline{B}$ fourni par l'inverseur L5 au niveau 0. La bobine du relais J2 n'est pas alimentée et ses contacts sont ouverts, de sorte que la batterie n'est pas traversée par un courant de charge rapide. Cependant, tant que la source fonctionne normalement, un courant de charge d'entretien est appliqué à la batterie, produisant un signal SP de niveau 1 et l'inverseur analogique P6 relie la sortie du convertisseur tension-fréquence 5 au diviseur K3. Mais les impulsions produites par le convertisseur sont déviées par la diode D3 et ne sont pas prises en compte par le circuit de comptage. Ainsi le courant de charge d'entretien, qui n'a pas d'effet sur l'état de charge de la batterie, ne modifie pas non plus l'état des compteurs qui en est l'image.

Si la source cesse d'être disponible et que la batterie 1 est appelée à débiter, le signal SP prend le niveau 0 et les impulsions du convertisseur 5 à une fréquence $f_o$ sont transmises au diviseur K2, puis, après division par $2^{18}$, aux compteurs K4 et K5 qui les comptent

négativement.

$f_o$ est égal à $a_o I$, avec $a_o = \dfrac{m}{j_o h_o}$ , m étant une constante du dispositif. Au rétablissement de la source, le régime de charge rapide est appliqué à la batterie (si la profondeur de décharge est suffisante pour que le signal B soit au niveau 0), le courant j prend la valeur $j_1$ ou $j_2$ selon la profondeur de décharge détectée par la porte L3 dont le signal de sortie A commande le transistor T1, et la durée h prend la valeur $h_1$ elle-même dépendant de $V_e$ donc du courant I. Le coefficient $\underline{a}$ devient donc $a_1 = \dfrac{m}{j_1 h_1}$ ou

$a_2 = \dfrac{m}{j_2 h_1}$ . Le signal SP étant revenu au niveau 1, les impulsions produites à la fréquence $f_1 = a_1 I$ ou $f_2 = a_2 I$ sont transmises au diviseur K3, puis après division aux compteurs K4 et K5 qui les enregistrent positivement. La charge rapide s'arrête lorsque les compteurs sont revenus à l'état initial 11001100, soit après comptage d'un nombre d'impulsions égal à celui enregistré en décharge. Le facteur de recharge est $k = \dfrac{a_o}{a_m}$ , $a_m$ étant la valeur moyenne de $\underline{a}$ au cours de la charge, qui est égale à $a_1$ si la profondeur de décharge n'a pas dépassé le seuil de basculement de la porte L3, et comprise entre $a_1$ et $a_2$, et d'autant plus faible que la décharge a été plus importante, dans le cas contraire. Le facteur de recharge est donc d'autant plus élevé que la décharge a été plus profonde, pour tenir compte du fait que le rendement de recharge est fonction décroissante de la profondeur de décharge.

Pour une profondeur de décharge constante le coefficient $a_m$ est inversement proportionnel à $h_1$ et peut s'écrire $a_m = \dfrac{m}{j_m h_1}$ , $j_m$ désignant la valeur moyenne du courant j au cours de la charge. Si on se reporte à la formule donnée plus haut et permettant de calculer $h_1$, on constate que celui-ci varie en fonction décroissante de la tension d'entrée $V_e$ du convertisseur 5, donc du courant I, $h_1$ étant égal à $h_o$ pour $V_e = 0$. Le coefficient de proportionnalité $a_m = \dfrac{m}{j_m h_1}$ varie donc en fonction croissante du courant I et le facteur de recharge $k = \dfrac{a_o}{a_m} = \dfrac{j_m h_1}{j_o h_o}$ en fonction décroissante de I.

Le champ de variation du facteur k peut être caractérisé par les quatre valeurs suivantes :

$$- k_{10} = \frac{j_1}{j_o} \text{ qui est la limite de } k_1 = \frac{a_o}{a_1} = \frac{j_1 h_1}{j_o h_o}$$

lorsque le courant de charge $I_1$ tend vers 0,

$$- k_{1M} = \frac{j_1 h_M}{j_o h_o} \text{ qui est la valeur de } k_1 \text{ correspondant au courant}$$

de charge maximal $I_{1M}$,

$$- k_{20} = \frac{j_2}{j_o} \text{ qui est la limite de } k_2 = \frac{a_o}{a_2} = \frac{j_2 h_1}{j_o h_o}$$

lorsque $I_1$ tend vers 0,

$$- k_{2M} = \frac{j_2 h_M}{j_o h_o} \text{ qui est la valeur de } k_2 \text{ correspondant au courant}$$

de charge maximal $I_{1M}$,

$h_M$ désignant la valeur de $h_1$ obtenue pour le courant $I_{1M}$.

Le courant de charge maximal $I_{1M}$ peut être imposé par construction lorsque le dispositif selon l'invention est incorporé à un appareil comportant des moyens de charge. A défaut d'une telle limite pratique on considèrera comme courant maximal celui qui ne doit pas être dépassé sous peine de détérioration des accumulateurs.

Ces quatre valeurs caractéristiques de k peuvent être fixées comme on le désire en jouant sur les rapports $\frac{j_1}{j_o}$, $\frac{j_2}{j_o}$ et $\frac{R22}{R14}$.

En effet les deux premiers de ces rapports définissent respectivement $k_{10}$ et $k_{20}$, et le troisième définit $\frac{h_M}{h_o} = \frac{k_{1M}}{k_{10}} = \frac{k_{2M}}{k_{20}}$.

A titre d'exemple, pour une batterie d'accumulateurs nickel-cadmium étanches à électrodes frittées minces fonctionnant dans une gamme de températures de 5 à 30°C environ, on peut adopter les valeurs suivantes :

$$k_{10} = 1,2 \qquad k_{20} = 1,44 \qquad k_{1M} = 1 \qquad k_{2M} = 1,2.$$

le courant $I_{1M}$ étant celui qui, intégré pendant une heure, fournit une quantité d'électricité égale à la capacité nominale de la batterie, et le passage du coefficient $a_1$ au coefficient $a_2$ se produisant pour une profondeur de décharge de 2,5 % environ.

Dans ces conditions le coefficient de recharge passe de 1,2 environ à 1,4 environ, selon la profondeur de décharge, pour un courant de charge très faible, et de 1 à 1,2 environ pour le courant de charge maximal.

L'invention n'est pas limitée au mode de réalisation décrit et représenté. En particulier lors de la décharge de la batterie l'extrémité de la résistance R22 opposée au condensateur C3, au lieu d'être reliée à la masse, peut être déconnectée. On aura alors

$$h_o = R14.C \: Log \: 3$$

ce qui multiplie par un facteur constant le rapport $\dfrac{h_1}{h_o}$ et n'en modifie donc pas la loi de variation avec I, de même que celle de $\dfrac{a_m}{a_o}$ à profondeur de décharge constante. Si on veut modifier cette loi de variation pour tenir compte d'une loi de variation donnée du rendement de charge, il faudra faire appel à d'autres moyens d'action sur le coefficient de conversion tension-fréquence, ces moyens n'étant pas eux-mêmes limités à l'exemple décrit. La grandeur g peut d'ailleurs être autre qu'une fréquence, et être intégrée sous une autre forme que celle d'un état logique.

La variation du coefficient a en fonction du courant de charge peut être mise en oeuvre indépendamment de sa variation en fonction de la profondeur de décharge, ou inversement combinée avec sa variation en fonction d'autres paramètres tels que la température de la batterie pendant la charge et/ou pendant la décharge. Par ailleurs des moyens de correction de l'information image de l'état de charge de la batterie peuvent être prévus pour tenir compte par exemple de son autodécharge en l'absence de courant.

**0012315**

REVENDICATIONS

1/ Procédé de suivi de l'état de charge d'un accumulateur, consistant à élaborer une grandeur g proportionnelle au courant I de charge ou de décharge de l'accumulateur et à intégrer algébriquement ladite grandeur en une information qui est l'image de l'état de charge de l'accumulateur, en donnant au coefficient de proportionnalité $a$ = g/I entre ladite grandeur et ledit courant une valeur plus faible en charge qu'en décharge, caractérisé par le fait qu'on fait varier la valeur du coefficient $a$ en charge en fonction croissante du courant I.

2/ Dispositif pour la mise en oeuvre du procédé selon la revendication 1, caractérisé par le fait qu'il comprend :

- un shunt (2) placé en série avec l'accumulateur (1) et dont la tension aux bornes est algébriquement proportionnelle au courant I,

- un circuit d'amplification (3) fournissant une tension amplifiée proportionnelle à la tension aux bornes du shunt,

- un convertisseur tension-fréquence (5) délivrant un train d'impulsions dont la fréquence, constituant ladite grandeur g, est proportionnelle à la valeur absolue de ladite tension amplifiée, avec un coefficient de proportionnalité fonction du signe de cette dernière, et de sa valeur absolue lorsque l'accumulateur est en charge,

- un circuit de comptage logique (7), sensible auxdites impulsions et au signe de la tension aux bornes du shunt, comptant positivement ou négativement lesdites impulsions selon ledit signe, et dont l'état logique représente ladite information.

3/ Dispositif selon la revendication 2, caractérisé par le fait que le rapport de conversion tension-fréquence dudit convertisseur (5) est sensible lors de la charge à ladite tension amplifiée qui constitue la tension d'entrée du convertisseur.

4/ Dispositif selon la revendication 3, caractérisé par le fait que ledit convertisseur (5) comprend un condensateur (C3) dont la durée de charge détermine ladite fréquence et dont le circuit de charge reçoit ladite tension amplifiée lors de la charge de l'accumulateur.

5/ Dispositif selon la revendication 4, caractérisé par le fait que ledit condensateur (C3) est branché en série avec une première résistance (R14) entre les bornes d'une source de tension constante, et qu'une seconde résistance (R22) est branchée en série avec ladite tension amplifiée en parallèle sur le condensateur, lors de la charge de l'accumulateur.

6/ Dispositif selon la revendication 5, caractérisé par le fait que ladite seconde résistance (R22) est branchée directement en parallèle sur le condensateur lors de la décharge de l'accumulateur.

0012315

FIG.1

FIG.2

2/2

0012315

Office européen
des brevets

**RAPPORT DE RECHERCHE EUROPEENNE**

0012315

Numéro de la demande

EP 79 10 4848

## DOCUMENTS CONSIDERES COMME PERTINENTS

| Catégorie | Citation du document avec indication, en cas de besoin, des parties pertinentes | Revendication concernée |
|---|---|---|
| A | <u>FR - A - 2 361 754</u> (SAFT)<br>* Page 2, lignes 12-36; page 10, lignes 1-12; revendication 1; figure 2a * | 1-2 |
| | -- | |
| A | <u>FR - A - 2 024 641</u> (HENGSTLER SYSTEM GmbH)<br><br>* Page 2, lignes 15-37; page 4, lignes 1-11; revendication 1; figure *<br>& DE - A - 1 811 950<br>  GB - A - 1 237 208 | 2 |
| | -- | |
| A | <u>FR - A - 2 258 012</u> (AKKUMULATOREN-FABRIK DR. LEPOLD JUNGFER)<br>* Page 3, à partir de ligne 38 à ligne 9, page 5; figure 3 *<br>& DE - A - 2 500 332<br>  AT - A - 331 357<br>  CH - A - 577 751<br>  US - A - 3 971 980<br>  GB - A - 1 476 259 | 1-3 |
| | ---- | |

**CLASSEMENT DE LA DEMANDE (Int. Cl. 3)**

H 02 J  7/10
G 01 R 31/36

**DOMAINES TECHNIQUES RECHERCHES (Int. Cl. 3)**

G 01 R 31/36
H 02 J  7/10

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achevement de la recherche | Examinateur |
|---|---|---|
| La Haye | 11-03-1980 | KUSCHBERT |

OEB Form 1503.1  06.78